# EUROPEAN PATENT APPLICATION

(11) **EP 3 900 843 A1**
(43) Date of publication of application: **27.10.2021**
(21) Application number: 19899183.8
(22) Date of filing: 18.12.2019
(51) Int. Cl.: B05C 5/02

(54) **SLIT COATER**

(30) Priority: 18.12.2018 JP 2018235964
(71) Applicant: Iinuma Gauge Manufacturing Co., Ltd., Chino-shi, Nagano 391-0011 (JP)
(72) Inventor: FUKUI, Katsuyuki, Chino-shi, Nagano 391-0011 (JP); MIYAZAKI, Daisuke, Chino-shi, Nagano 391-0011 (JP)
(74) Representative: Liesegang, Eva
(86) International application number: PCT/JP2019/049660
(87) International publication number: WO 2020/130045

(57) **Abstract**

[Problem to be Solved]

To provide a slit coater capable of forming a coated film having an arbitrary shape by easily switching a slit gap.

[Solution]

A slit coater 1 includes: a slit die 20 which has a fixed die plate 24, a movable die plate 21 which is movable in a length direction with respect to the fixed die plate 24, and a slit-shaped nozzle 81 formed on a joining face between the fixed die plate 24 and the movable die plate 21; a movable die plate slide mechanism 23 capable of changing a slit length of the slit-shaped nozzle 81 by moving the movable die plate 21; a slit die slide mechanism 22 capable of moving the slit die 20 along the main frame 8; and a stage drive mechanism 12 capable of transporting a substrate 3. Shim plates 76, 71 which define a size of a slit gap G of the slit-shaped nozzle 81 are respectively detachably and fixedly mounted on the fixed die plate 24 and the movable die plate 21.

## Description

### Technical Field

The present invention relates to a slit coater.

### Background Art

Conventionally, there has been known a slit coater which uses a slit coating method where a coated film is formed by ejecting a liquid such as a resist, a particular film material or an adhesive agent onto a work from a slit-shaped nozzle. Such a slit coater has favorable characteristics such as higher film coating accuracy, a higher coating speed and a favorable use efficiency of a liquid (liquid agent) compared to a slit coater which uses a spin coating method and hence, the slit coater using a slit coating method has been popularly used as a coated film forming apparatus.

In the conventional slit coater which uses the slit coating method, a slit-shape nozzle which ejects a liquid by interposing a shim plate between two die plates is formed. In such a slit coater, a coated film having a rectangular shape can be formed. However, the slit coater cannot form a coated film having a curved portion such as a circular shape. Accordingly, there has been a demand for a slit coater which can form a coated film having a curved portion.

Patent literature 1 discloses a slit coater capable of forming a coated film having a rectangular shape and a curved portion having a circular shape or the like. Such a slit coater adopts a structure where a slit-shaped nozzle is formed by joining stepped portions of two die plates (a front lip member and a rear lip member) in a staggered manner, and a length of the slit-shaped nozzle (hereinafter, described as a slit length) can be changed by moving two die plates relative to each other.

Patent literature 2 discloses a structure where a shim plate (sealing member) is disposed on both ends of two die plates (a chamber plate and a blocking plate) in a length direction, a slit-shaped nozzle is formed by the shim plates and two die plates, and a slit length can be changed at the time of forming a coated film by changing a distance between two shim plates. With the use of such a slit coater, a coated film having a rectangular shape and a curved shape such as a circular shape can be formed.

### Citation List

### Patent Literature

Patent literature 1: JP 2004-313874 A
Patent literature 2: JP 2018-69230 A

### Summary of Invention

### Technical Problem

However, in the slit coaters described in patent literature 1 and patent literature 2, although the slit length can be changed, it is difficult to change a gap (also referred to as slit gap) at a joining portion of two die plates as desired. For example, in patent literature 1, the slit gap is changed by changing shape (stepped portions) of two die plates, and in patent literature 2, the slip gap is changed by changing thicknesses and configurations of the shim plates are changed. Accordingly, both slit coaters described in patent literature 1 and patent literature 2 have a drawback that the slit gap cannot be easily changed. In patent literature 2, a shimmember moving unit is disposed between two die plates and hence, the slit coater described in patent literature 2 has a complicated structure. Accordingly, an exchange of the shim plates becomes further difficult. It is preferable that the slit gap be properly adjusted in view of fluidity (viscosity) of a liquid to be ejected. That is, there has been a demand for a slit coater which can adjust a slit gap corresponding to viscosity and a coating speed of a liquid to be discharged.

The sealing member described in patent literature 2 is configured such that the slit length changes by moving two shim plates with the rotation of a common screw shaft having left threads and right threads on both ends. Since two shim plates move in opposite directions at a same moving speed, a coating width has a symmetrical shape with respect to a center reference line. Accordingly, the slit coater described in patent literature 2 has a drawback that the slit coater cannot form a coated film having an arbitrary shape such as a combination of a straight line and a curved line.

The present invention has been made to overcome such drawbacks, and it is an object of the present invention to provide a slit coater which, while making use of characteristics of a conventional slit coating method, can easily cope with a kind (difference in viscosity) and an ejection speed of a liquid to be ejected, and can form a coated film having an arbitrary shape such as a rectangular shape, curved lines, or a combination of a straight line and a curved line.

### Solution to Problem

[1] A slit coater according to the present invention is a slit coater capable of forming a coated film by ejecting a liquid onto a work using a slit coating method. The slit coater includes: a slit die mounted on a main frame, the slit die including: a fixed die plate; a movable die plate which is slidably movable in a length direction with respect to the fixed die plate; and a slit-shaped nozzle which is formed on a joining face between the fixed die plate and the movable die plate; a movable die plate slide mechanism capable of changing a slit length of the slit-shaped nozzle by slidably moving the movable die plate; a slit die slide mechanism capable of slidably moving the slit die along the main frame; and a stage drive mechanism capable of sucking work onto a stage and capable of transporting the work. Shim plates which define a size of a slit gap of the slit-shaped nozzle are respectively detachably and fixedly mounted on the fixed die plate and the movable die plate.
   According to the slit coater of the present invention, the slit gap of the slit-shaped nozzle can be easily switched by controlling thicknesses of two shim plates interposed between the movable die plate and the fixed die plate. The slit length can be changed as desired by moving the movable die plate with respect to the fixed die plate in the length direction of the slit-shaped nozzle. Accordingly, the slit coater of the present invention can while making use of characteristics of a conventional slit coating method, can easily cope with a kind (difference in viscosity) and an ejection speed of a liquid to be ejected, and can form a coated film having an arbitrary shape such as a rectangular shape, curved lines, or a combination of a straight line and a curved line. In the slit coater of the present invention, "slit length" is a length which corresponds to a coated film width of the slit-shaped nozzle, and "slit gap" is a gap width between the fixed die plate and the movable die plate. As the liquid, a resist, a particular film material, an adhesive agent (UV adhesive agent) or the like can be used.
[2] In the slit coater of the present invention, it is preferable that the movable die plate slide mechanism and the slit die slide mechanism be connected to one motor by means of a plurality of gears, a moving distance of the slit die be 1/2 of a moving distance of the movable die plate, and a moving direction of the slit die be a direction opposite to a moving direction of the movable die plate.
   With such a configuration, the movable die plate and the fixed die plate synchronously move relative to each other in opposite directions. Since the moving distance of the slit die is set to 1/2 of the moving distance of the movable die plate, distributed coating in line symmetry with respect to the reference line (center line), so-called center equally distributed coating can be performed. Liquid coating having a quadrangular shape, a polygonal shape or a circular shape can be performed by controlling a moving speed and a moving distance of the movable die plate and a moving speed (coating speed) of the substrate. For example, the coated film S having a circular shape which conforms with a profile of a semiconductor wafer can be formed.
[3] In the slit coater of the present invention, it is preferable that the slit die slide mechanism and the movable die plate slide mechanism each have a motor, and the motor of the slit die slide mechanism and the motor of the movable die plate slide mechanism be driven independently from each other.
   With such a configuration, a moving speed, a moving direction and a moving distance of the slit die can be arbitrarily controlled compared to a case where the slit length is changed by the movement of the movable die plate. Accordingly, the coated film having an arbitrary shape such as a rectangular shape, a polygonal shape or a combination of a straight line and a curved line can be formed. Needless to say that the center equally distributed coating can be also performed.
[4] In the slit coater of the present invention, it is preferable that the movable die plate and the fixed die plate each have a manifold portion for supplying the liquid to the slit-shaped nozzle, the manifold portion of the movable die plate and the manifold portion of the fixed die plate communicate with each other so as to form one manifold, and a volume of the one manifold be constant regardless of a moving position of the movable die plate.
   With such a configuration, when the movable die plate moves with respect to the fixed die plate, the volume of the manifold does not change and hence, a liquid can be stably supplied to the slit-shaped nozzle even when the slit length changes and hence, ejection uniformity can be ensured. That is, a thickness and a shape of the coated film can be formed with high accuracy.
[5] In the slit coater of the present invention, it is preferable that the movable die plate and the fixed die plate be guided by a parallel key extending in a moving direction of the movable die plate.
   With such a configuration, when the movable die plate moves with respect to the fixed die plate, it is possible to prevent the movable die plate from being inclined with respect to the fixed die plate and hence, sliding property can be enhanced. Further, a gap formed between a discharge opening portion of the slit-shaped nozzle and the work can be made uniform and hence, coating accuracy can be enhanced.
[6] In the slit coater of the present invention, it is preferable that the slit coater further include a liquid amount controller capable of controlling a supply amount of the liquid to the manifold corresponding to a change in a slit length of the slit-shaped nozzle and a moving speed of the work in forming a coated film on the work by ejecting the liquid onto the work.
   By controlling a liquid supply amount corresponding to an ejection amount of the liquid, a desired coated film shape can be formed with the supply of the liquid without an excess and a shortage of the liquid. Further, it is possible to prevent the generation of bubbles caused by a shortage of the liquid in a liquid supply path.
[7] In the slit coater of the present invention, it is preferable that the slit coater according further include a feeding speed controller capable of controlling a moving speed of the work in synchronism with a change in the slit length by setting a supply amount of the liquid to a constant value.
   For example, when the slit length is increased, an ejection amount is increased and hence, there is no possibility that the liquid becomes short by decreasing a feeding speed of the work. Further, when the slit length is decreased, it is possible to prevent an excessive ejection of the liquid by increasing a feeding speed of the work.
[8] In the slit coater of the present invention, it is preferable that the liquid which is an object to be coated be coated on a slide face between the movable die plate and the fixed die plate.
   By preliminarily coating a liquid which is an object to be coated to the slide face between the movable die plate and the fixed die plate, a film formed of the liquid becomes a lubricant and hence, sliding property between the movable die plate and the fixed die plate can be increased. When a lubricant other than the object to be coated is used, the liquid which is the object to be coated and the lubricant are mixed with each other and hence, there is a concern that the liquid is solidified by a chemical reaction. Accordingly, it is preferable to use the liquid which is the object to be coated as a lubricant.
[9] In the slit coater of the present invention, it is preferable that the slit coater further include a pressing unit formed of: a roller which presses the movable die plate to the fixed die plate; and a cam follower base which supports the roller.
   By bringing the movable die plate and the fixed die plate into close contact with each other by such a pressing unit, the occurrence of a leakage of a liquid from the slide face can be prevented and hence, the slit gap can be maintained at a constant value. Further, by using the roller as the pressing unit, the increase of a friction load of the movable die plate can be suppressed and hence, sliding property can be maintained.
[10] In the slit coater of the present invention, it is preferable that the slit coater further include a slit die rotating mechanism unit which is, in a state where the work has a curved surface in a thickness direction, capable of inclining the slit die so as to dispose the slit-shaped nozzle on an extension of a normal line of the curved surface.

With such a configuration, a coated film can be formed also on the work having a curved surface with high accuracy. When the work has a flat surface, the slit die rotating mechanism may be controlled such that the slit-shaped nozzle is disposed on a line perpendicular to a flat surface.

### Brief Description of Drawings

Fig. 1 is a perspective view showing an overall configuration of a slit coater 1 according to an embodiment.
Fig. 2 is a front view of a slit die mechanism unit 2A as viewed from a front side in Fig. 1.
Fig. 3 is a plan view of the slit die mechanism unit 2A as viewed from above in Fig. 2.
Fig. 4 is a cross-sectional view of the slit die mechanism unit 2A taken along a line A-A in Fig. 3.
Fig. 5 is a side view schematically showing an arrangement of a gear train as viewed from a right side in Fig. 2.
Fig. 6 is a perspective view showing a configuration of a slit die 20.
Fig. 7 is an exploded view of an assembly of the slit die 20.
Fig. 8 is a cross-sectional view of the slit die 20 taken along a line A-A in Fig. 6.
Fig. 9 is an explanatory view schematically showing an operation of the slit die 20 at the time of forming a coated film.
Fig. 10 is an explanatory view schematically showing an operation of the slit die 20 in forming a circular coated film S.
Fig. 11 is a view showing examples of a shape of the coated film S when an ejection head mechanism unit 2A is used.
Fig. 12 is a plan view showing a configuration of an ejection head mechanism unit 2B.
Fig. 13 is a side view schematically showing an arrangement of the gear train and a motor 91 as viewed from a right side in Fig. 12.
Fig. 14 is a view illustrating examples of a shape of the coated film S which can be formed when only a movable die plate slide mechanism 223 is driven in a state where the slit die slide mechanism 90 is stopped.
Fig. 15 is a view illustrating examples of a shape of the coated film S which can be formed when the slit die slide mechanism 90 and the movable die plate slide mechanism 23 are driven in desired combinations.
Fig. 16 is an explanatory view schematically showing a method of forming the coated film S on a substrate 3 having a curved surface and an inclined surface.

### Description of Embodiment

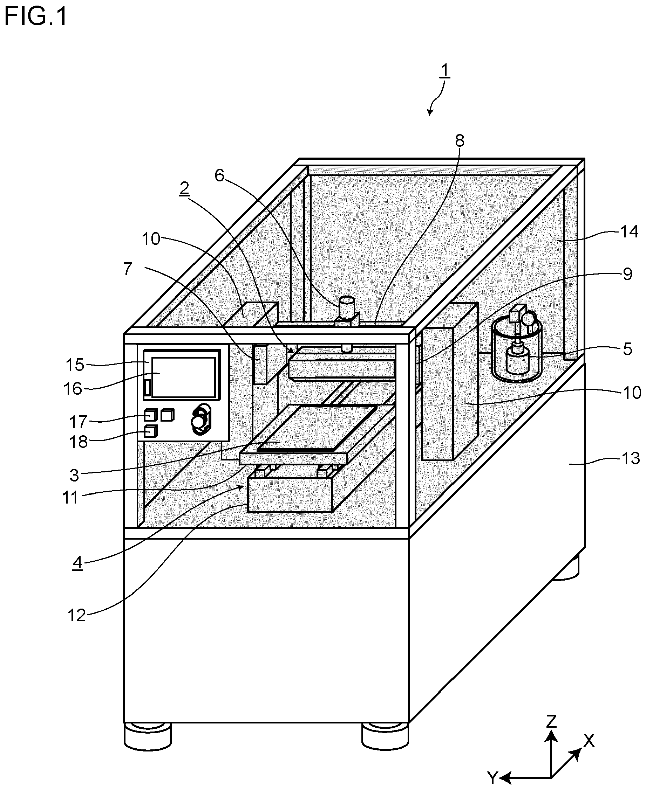

Hereinafter, a slit coater 1 according to the embodiment of the present invention is described with reference to Fig. 1 to Fig. 15. The slit coater 1 is an apparatus which forms a coated film by ejecting a liquid onto a work using a slit coating method. As a work, various works are considered including a plate member, a circuit board, a flexible printed circuit board and a semiconductor wafer. In the description made hereinafter, the description is made by setting a substrate 3 as an example of the work 1.

### [Overall configuration of slit coater 1]

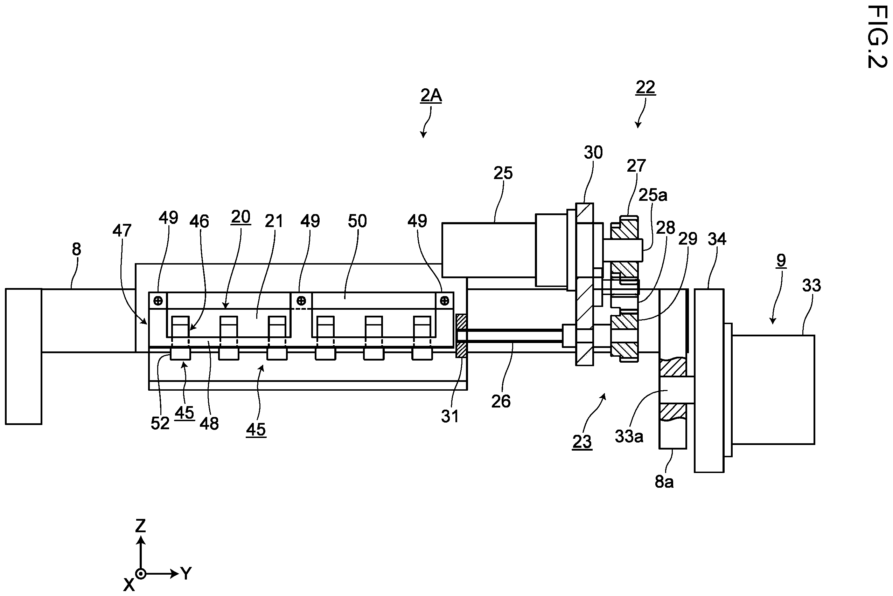

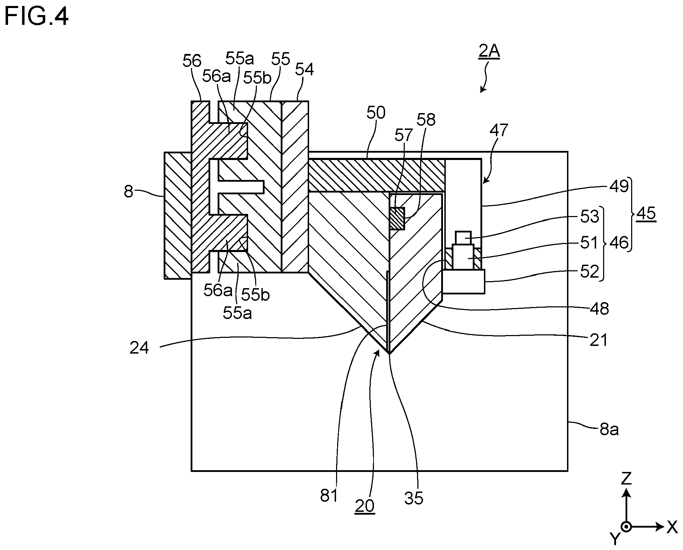

Fig. 1 is a perspective view showing an overall configuration of the slit coater 1 according to an embodiment of the present invention. In the respective drawings described hereinafter, a depth direction in Fig. 1 is set as an X direction, a direction orthogonal to the X direction is set as a Y direction or a lateral direction, and a direction orthogonal to an X-Y plane is set as a Z direction or a vertical direction. Further, in the respective drawings described hereinafter, a magnification ratio is suitably changed. The slit coater 1 includes : an ejection head mechanism unit 2 which ejects a liquid; a stage drive mechanism unit 4 which sucks the substrate 3 which is a work and moves in the X direction; and a pump 6 which sucks a liquid from a liquid supply tank 5 and supplies the liquid to the ejection head mechanism unit 2 (to be more specific, a slit die 20, see Fig. 2 and Fig. 4) . The X direction is a direction along which the substrate 3 moves relative to the ejection head mechanism unit 2, and is a direction along which a coated film is formed.

The ejection head mechanism unit 2 is elevated or lowered in the Z direction with respect to the substrate 3 by a Z axis drive mechanism unit 7. The ejection head mechanism unit 2 is mounted on a main frame 8 which extends in the Y axis direction such that the ejection head mechanism unit 2 is movable in the Y direction. An end portion of the main frame 8 on a right side in the drawing is connected to a slit die rotating mechanism unit 9. The slit die rotating mechanism unit 9 has a function of rotating the ejection head mechanism unit 2 in a direction orthogonal to an extending direction of the main frame 8. The main frame 8 is horizontally supported on two posts 10, 10 erected on both left and right sides.

The stage drive mechanism unit 4 includes: a stage 11 which sucks the substrate 3 by vacuum suction; a stage drive mechanism 12 which moves the stage 11 in the X direction. The liquid supply tank 5 and the pump 6 are connected to each other by a liquid transport tube not shown in the drawing. The ejection head mechanism unit 2, the stage drive mechanism unit 4, the liquid supply tank 5, the pump 6, the Z axis drive mechanism unit 7, the stage drive mechanism 4 and the like are disposed in a booth 14 disposed above a base 13. The slit coater 1 shown in Fig. 1 is configured to move the substrate 3 (substrate stage 8) in the X direction with respect to the ejection head mechanism 2. However, the slit coater 1 may also be configured to move the ejection head mechanism unit 2 in the X direction in a state where the stage 11 is fixed.

An operation panel 15 is disposed on a front side of the slit coater 1 in the drawing. The operation panel 15 has a display unit 16, an input button 17, an ON/OFF switch 18 and the like. The display unit 16 is a liquid crystal display, an organic EL display or the like which displays drive conditions, drive information and the like. Although not shown in the drawing, a controller which controls entire driving of the slit coater 1 is disposed in a space on a deep side in the booth 14 in the drawing.

### [Configuration of ejection head mechanism unit 2A]

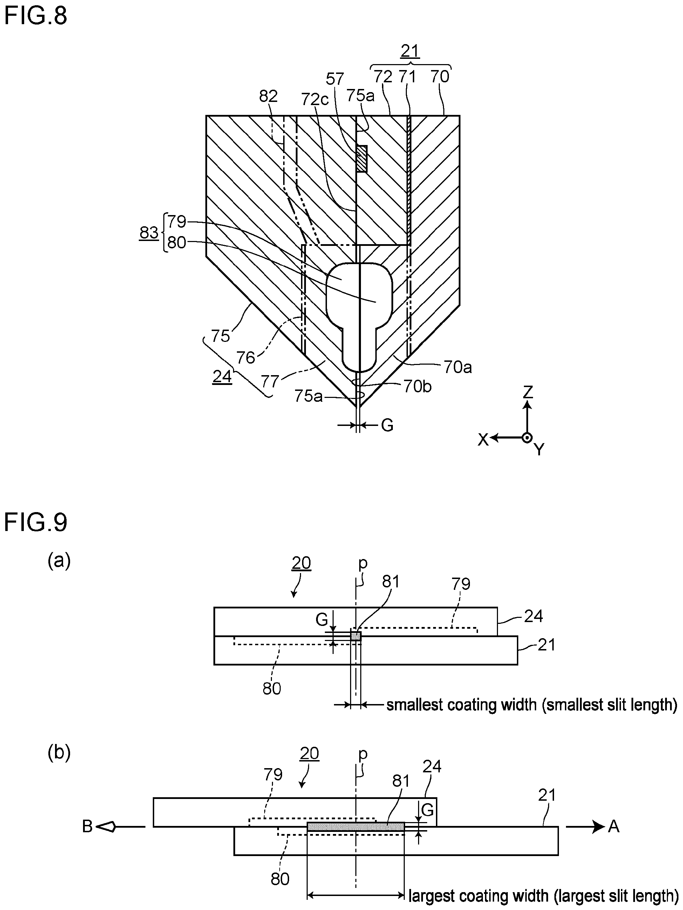

The ejection head mechanism unit 2 described hereinafter includes: a configuration capable of performing equally distributed coating in a left and right symmetry with respect to a reference line P (see Fig. 9) (ejection head mechanism unit 2A); and a configuration capable of performing coating in an arbitrary shapes on left and right sides with respect to a reference position (ejection head mechanism unit 2B). Firstly, the configuration of the ejection head mechanism unit 2A is described with reference to Fig. 2 to Fig. 5.

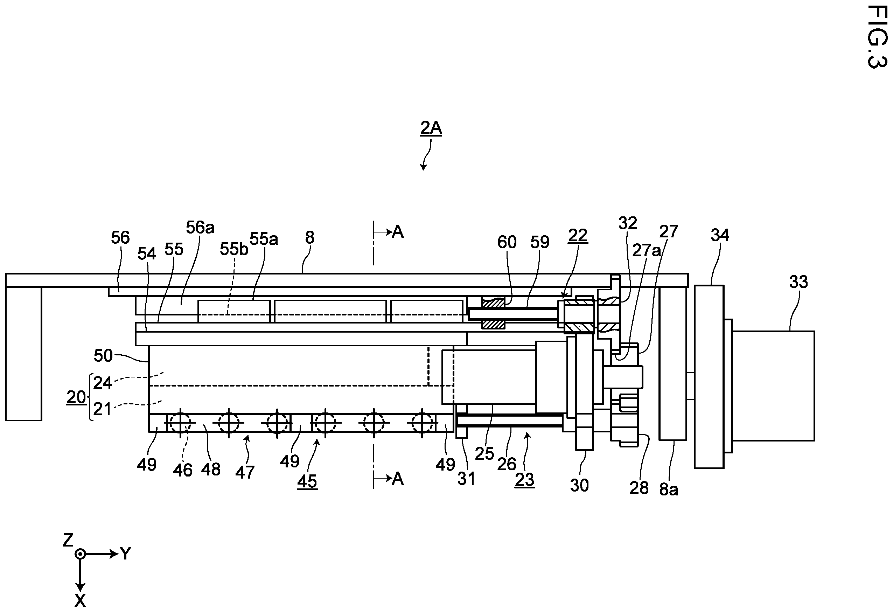

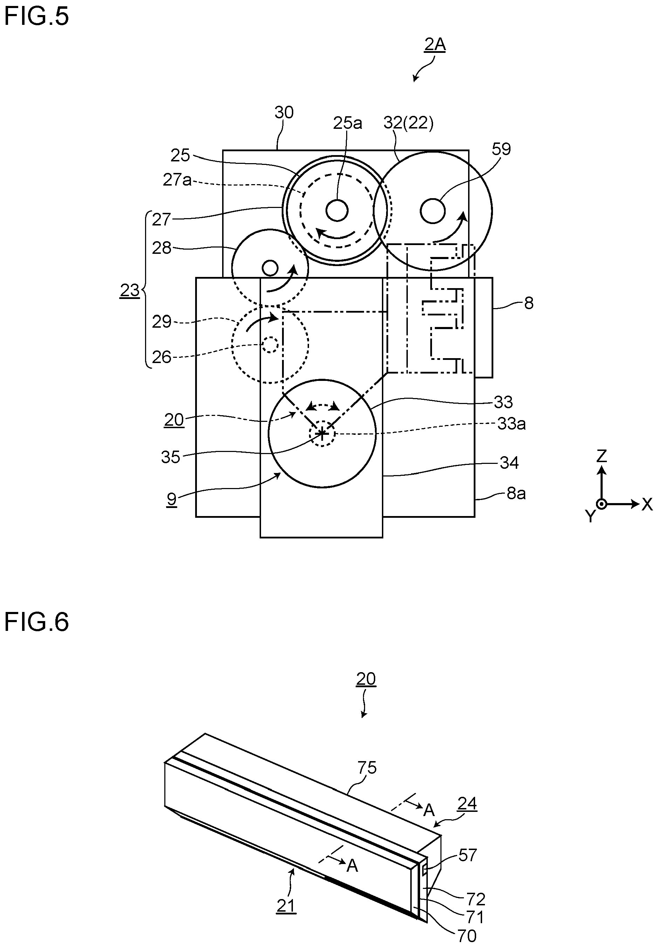

Fig. 2 is a front view of the slit die mechanism unit 2A as viewed from a front side in Fig. 1, Fig. 3 is a plan view of the slit die mechanism unit 2A as viewed from above in Fig. 2, Fig. 4 is a cross-sectional view of the slit die mechanism unit 2A taken along a line A-A in Fig. 3, and Fig. 5 is a side view schematically showing an arrangement of a gear train as viewed from a right side in Fig. 2. The slit die mechanism unit 2A includes: a slit die 20 (see Fig. 4) which is mounted on the main frame 8 in a slidably movable manner in a lateral direction (Y direction); a slit die slide mechanism 22 (see Fig. 3) which moves the slit die 20 along the main frame 8 in the Y direction in a reciprocating manner; a movable die plate slide mechanism 23 which moves a movable die plate 21 in the lateral direction (Y direction) in the drawings; and a slit die rotating mechanism unit 9 which rotates the main frame 8 in a direction orthogonal to an extending direction of the main frame 8 in a state where the slit die 20 is mounted on the main frame 8. Fig. 2 shows a state where the movable die plate 21 is disposed at the reference position where the movable die plate 21 is not moved with respect to a fixed die plate 24 (see Fig. 6).

Next, the configuration of the movable die plate slide mechanism 23 is described with reference to Fig. 2 and Fig. 5. The movable die plate slide mechanism 23 includes a motor 25 and a gear train which transmits the rotation of the motor 25 to a screw shaft 26. The gear train is formed of a first gear 27 which is fixedly mounted on a motor shaft 25a, a second gear 28 and a third gear 29. The third gear 29 is fixedly mounted on the screw shaft 26. The motor 25 and the second gear 28 are rotatably supported by a gear support plate 30. A left distal end portion of the screw shaft 26 threadedly engages with a threads formed block 31, and a right distal end side of the screw shaft 26 is rotatably supported by the gear support plate 30.

The threads formed block 31 is fixedly mounted on the movable die plate 21. The movable die plate slide mechanism 23 is a so-called screw drive mechanism, and the threads formed block 31 has a function of a slider nut with respect to the screw shaft 26. The screw shaft 26 has right threads. Accordingly, when the screw shaft 26 is rotated in a clockwise direction, the threads formed block 31 moves in the right direction in the drawing integrally with the movable die plate 21 although the position of the screw shaft 26 is not changed, and when the screw shaft 26 is rotated in a counterclockwise direction, the threads formed block 31 moves in the left direction in the drawing integrally with the movable die plate 21 although the position of the screw shaft 26 is not changed. In Fig. 5, the rotational directions of the motor 25 and the respective gears when the screw shaft 26 is rotated in the clockwise direction are indicated by a solid-line arrow. A servo motor is used as the motor 25. Alternatively, a motor having a rotary encoder or a device equipped with a linear encoder which detects movement of the movable die plate 21 may be also used.

As shown in Fig. 3 and Fig. 5, a small gear 27a of the first gear 27 meshes with a fourth gear 32. The fourth gear 32 is provided for driving the slit die slide mechanism 22, and transmits the rotation of the motor 25 to a screw shaft 59. A gear tooth ratio between the fourth gear 32 and the third gear 29 is set to 2:1. In synchronism with the rotation of the motor 25, the third gear 29 and the fourth gear 32 are synchronously rotated in opposite directions from each other with respect to the rotation of the motor 25. That is, when the third gear 29 is rotated by one turn, the fourth gear 32 is rotated by 1/2 turn. The configuration of the slit die slide mechanism 22 is described in detail later with reference to Fig. 2.

As shown in Fig. 2 and Fig. 3, the ejection head mechanism unit 2A includes a motor 33. The motor 33 is mounted on a motor backup plate 34. The motor shaft 33a penetrates the motor backup plate 34, and is pivotally supported by a side plate portion 8a of the main frame 8. The motor backup plate 34 is fixedly mounted on the posts 10 (see Fig. 1). The position of a center axis of the motor shaft 33a overlaps with a distal end portion (outlet opening potion 35 for a liquid, see Fig. 5) of the slit die 20. Accordingly, by rotating the motor shaft 33a in a clockwise direction and a counterclockwise direction, it is possible to rotate the slit die 20 about an outlet opening portion 35 in a direction indicated by a dotted line arrow in the drawing by way of the main frame 8 (see Fig. 5). A servo motor provided with a speed reduction gear is preferably used as the motor 33.

Next, the configuration of a pressing unit 45 which presses the movable die plate 21 to the fixed die plate 24 is described with reference to Fig. 2 and Fig. 4. The pressing unit 45 includes six cam shafts 46 and a cam follower base 47 which supports the cam shafts 46. The cam follower base 47 has a base portion 48 and three columnar portions 49 which are formed on the base portion 48 in an upwardly protruding manner from the base portion 48. The columnar portions 49 of the cam follower base 47 are fixedly mounted on a support frame 50 by screws or the like. The cam shaft 46 is formed of a shaft portion 51, a roller 52 and an operating portion 53 formed on a distal end portion of the shaft portion 51. The cam shaft 46 penetrates the base portion 38 from below. The roller 52 is fixedly mounted on the shaft portion 51 by way of a bearing not shown in the drawing. The roller 52 is eccentric with respect to a center axis of the shaft portion 51. Since the roller 52 is an eccentric roller, due to the rotation of the shaft portion 51, the movable die plate 21 is pressed to the fixed die plate 24. A hexagonal socket is formed on a distal end of the operating portion 53 and hence, the operating portion 53 can be rotated by a hexagonal wrench.

The support frame 50 is fixedly mounted on the main frame 8 by way of a support plate 54, a slider 55 and a slider base 56. Accordingly, the slit die 20 is sandwiched between the support plate 54 and the rollers 52 in a pressed manner. The slit die 24, the support plate 54 and the slider 55 can be integrally moved with respect to the main frame 8 in the Y direction.

By pressing the movable die plate 21 to the fixed die plate 24 by the pressing unit 45, a leakage of a liquid from between the movable die plate 21 and the fixed die plate 24 is prevented. The pressing unit 45 presses the movable die plate 21 to the fixed die plate 24 by way of the rollers 52 each having a bearing. Accordingly, the rollers 52 are rotated during pressing the fixed die plate 24 and hence, there is no possibility that an excessively large pressing force is given to the movable die plate 21 whereby the movable die plate 21 can be moved smoothly. The support frame 50 is fixedly mounted on the main frame 8 by way of the support plate 54, the slider 55 and the slider base 56.

The fixed die plate 24 has a parallel key 57 which is mounted on the fixed die plate 24 in a protruding manner toward the movable die plate 21. A key groove 58 is formed on the movable die plate 21. The parallel key 57 engages with the key groove 58 by fitting, and guides the movable die plate 21 such that the movable die plate 21 is not inclined with respect to the fixed die plate 24. Although not shown in the drawings, a bolt is provided for pressing a top surface of the movable die plate 21 toward a downward side from above the support frame 50. With such a configuration, the movable die plate 21 is pressed to the parallel key 57 and hence, it is possible to prevent a leakage of a liquid from above the slit die 20.

Next, the configuration of the slit die slide mechanism 22 is described with reference to Fig. 3 and Fig. 4. The rotation of the motor 25 is transmitted to the fourth gear 32 by way of the small gear 27a of the first gear 27, and rotates the screw shaft 59. The screw shaft 59 is threadedly engaged with the threads formed block 60 fixedly mounted on the slider 55. Left threads are formed on the screw shaft 59 so that the slit die 20 moves in the direction opposite to the moving direction of the movable die plate 21 in an interlocking manner with the rotation of the motor 25. The threads formed block 60 has a function of a slider nut.

The slider 55 has two protruding ridge portions 55a extending parallel to each other in the length direction, and a groove 55b is formed on the respective protruding ridge portions 55a. On the other hand, two parallel protruding ridge portions 56a which engage with the grooves 55b by fitting are formed on the slider base 56. With such a configuration, the slit die 20 can be moved parallel to the main frame 8. The slit die 20 and the movable die plate 21 can be moved relative to each other in opposite directions synchronously. To be more specific, with respect to a moving amount of the movable die plate 21, the slit die 20 moves in the opposite direction by 1/2 of the moving amount of the movable die plate 21. Accordingly, a liquid can be coated on the substrate 3 in an equally distributed manner in a left and right symmetry with respect to the reference line P (see Fig. 9). This operation is described later with reference to Fig. 9.

### [Configuration of slit die 20]

Next, the configuration of the slit die 20 is described with reference to Fig. 6 to Fig. 8.

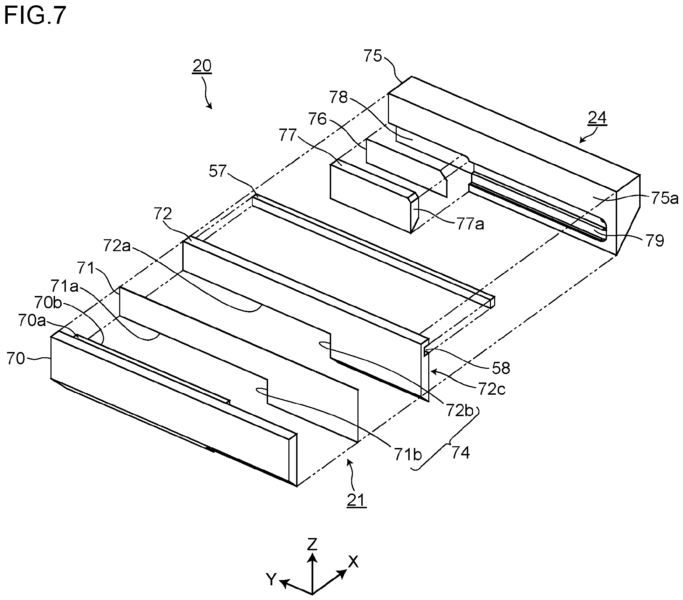

Fig. 6 is a perspective view showing a configuration of the slit die 20, Fig. 7 is an exploded view of an assembly of the slit die 20, and Fig. 8 is a cross-sectional view of the slit die 20 taken along a line A-A in Fig. 6. In Fig. 6 to Fig. 8, the slit die 20 is described in a simplified form, and the illustration of auxiliary constitutional elements such as a mounting jig are not shown in the drawings. The slit die 20 is formed of the movable die plate 21 and the fixed die plate 24. The movable die plate 21 is formed of a die plate base 70, a shim plate 71 and a shim plate base 72 which are stacked in a close contact manner. The shim plate 71 is sandwiched between the die plate base 70 and the shim plate base 72, and the shim plate 71, the die plate base 70 and the shim plate base 72 are joined to each other by screws. As shown in Fig. 7, a cutout portion 71a is formed in the shim plate 71, and a cutout portion 72a is formed in the shim plate base 72. In a state where the shim plate 71 and the shim plate base 72 are joined to each other, end surfaces 71b, 72b of the respective cutout portions 71a, 72a form an end surface 74 which defines a length (slit length) of a slit gap G (see Fig. 8 and Fig. 9) .

The key groove 58 with which the parallel key 57 engages by fitting is formed on a surface 72c of the shim plate base 72 on a die plate 75 side. The parallel key 57 is fixedly mounted on the die plate 75 by screws or the like. A protruding portion 70a is formed on a die plate base 70 on the die plate 75 side in a protruding manner, a manifold portion 80 (see Fig. 8) is formed on a top surface 70b of the protruding portion 70a on the die plate 70 side. The protruding portion 70a penetrates the cutout portion 71a of the shim plate 71, and protrudes to an intermediate portion of the cutout portion 72a of the shim plate base 72 in thickness.

The fixed die plate 24 is formed of the die plate 75, a shim plate 76 and a shim plate block 77 which are stacked in a close contact manner. The shim plate 76 and the shim plate block 77 engage with, by fitting, a recessed portion 78 formed on the die plate 75 on a left side in the drawing, and are detachably and fixedly mounted on the die plate 75 by screws or the like. The shim plate block 77 protrudes from a surface 75a of the die plate 75 which faces the shim plate base 72, and the shim plate block 77 is engageable with, by fitting, respective cutout portions 72a, 71a of the shim plate base 72 and the shim plate 71 on an inner side in the left direction in the drawing. An end surface 77a of the shim plate block 77 on a right side in the drawing defines a length (slit length) of one side of a slit gap G (see Fig. 8). When the movable die plate 21 and the fixed die plate 24 are joined to each other, a distance between the end surface 74 on a movable die plate 21 side and the end surface 77a on a fixed die plate 24 side becomes the slit length.

A manifold portion 79 is formed on the surface 75a of the die plate 75 on the movable die plate 21 side. As shown in Fig. 9, the manifold portions 79, 80 are disposed so as to intersect with each other at a center portion in the Y direction, and the manifold portions 79, 80 have the same shape and the same size. However, slight difference in shape and size is allowable between the manifold portions 79, 80. In joining the movable die plate 21 and the fixed die plate 24, by preliminarily coating a liquid which is an object to be coated to the surface 75a of the die plate 75 as a lubricant, it is possible to reduce a frictional load when the movable die plate 21 moves with respect to the fixed die plate 24. When a lubricant other than the object to be coated is used, it is considered that a liquid which is the object to be coated is solidified or degraded. However, with the use of the liquid which is the object to be coated, there is no such concern. When the movable die plate 21 and the fixed die plate 24 are joined to each other, the respective surfaces 72c, 75a of the shim plate base 72 and the die plate 75 form slide faces. As shown in Fig. 7, the shim plates 71, 76 are formed of plate members each having a uniform thickness, and are detachable. Accordingly, the thicknesses of the shim plates 71, 76 can be easily changed. That is, the adjustment of the slit gap G can be easily performed.

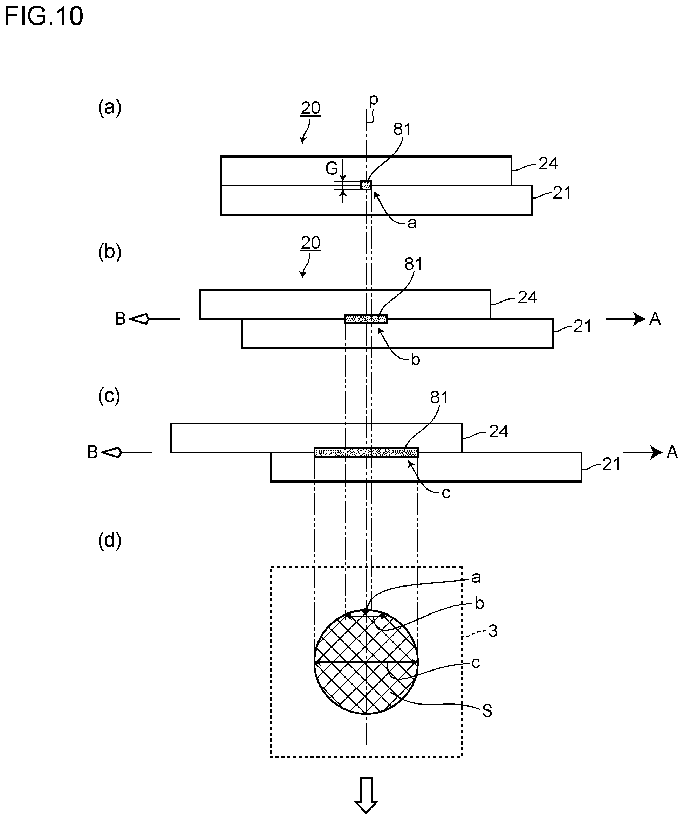

As shown in Fig. 8, the slit gap G is formed between the movable die plate 21 and the fixed die plate 24. To be more specific, a gap defined between the top surface 70b of the protruding portion 70a on a shim plate base 70 side and the surface 75a of the die plate 75 forms the slit gap G. A range where the slit gap G is formed is defined as a slit-shaped nozzle 81. The slit gap G can be easily switched by changing thicknesses of the shim plates 71, 76 each formed of the plate member having a simple shape. For example, by increasing the thickness of the shim plate 71, the shim plate block 77 presses the die plate base 70 toward a left side in the drawing so that the slit gap G is increased. In this case, by setting the thickness of the shim plate 71 equal to the thickness of the shim plate 76, the surface 72c of the shim plate base 72 is brought into close contact with the surface 75a of the die plate 75 which faces the surface 72c. A supply path 82 through which a liquid which is an object to be coated is supplied from the pump 6 communicates with the manifold portion 79. A coated film forming operation is described with reference to Fig. 9 and Fig. 10.

### [Coated film forming operation]

Fig. 9 is an explanatory view schematically showing an operation of the slit die 20 at the time of forming a coated film, and Fig. 10 is an explanatory view schematically showing an operation of the slit die 20 in forming a coated film having a circular shape. Fig. 9 (a) is a view showing an initial state before a coating operation is performed, and shows a state where the movable die plate 21 and the slit die 20 do not move. In this state, the slit length of the slit-shaped nozzle 81 takes a smallest coating width (smallest slit length). A straight line which passes through the center of the slit length is expressed as the reference line P. The manifolds 79, 80 intersect with each other within a range where the slit-shaped nozzle 81 is formed. The smallest slit length may be also set to "0".

Fig. 9(b) shows a case where the slit length is largest, that is, the case where the slit length has a largest coating width. The largest coating width can be obtained by moving the movable die plate 21 by a largest distance in a direction indicated by an arrow A. The slit die 20 moves in the opposite direction. A moving distance of the slit die 20 is 1/2 of a moving distance of the movable die plate 21 and hence, a coating width becomes a left and right symmetric width with respect to the reference line P in the drawing. By moving the movable die plate 21 and the slit die 20 in this manner, so-called center equally distributed coating with respect to the reference line P can be realized. During the transition from the smallest coating width state to a largest coating width state, a sum of volumes of the manifold portions 79, 80 does not change and hence, a liquid can be supplied to the slit-shaped nozzle 81 without an excess or a shortage of the liquid in any state. The slit gap G does not change. Next, an example where a circular coated film S is formed is described with reference to Fig. 10.

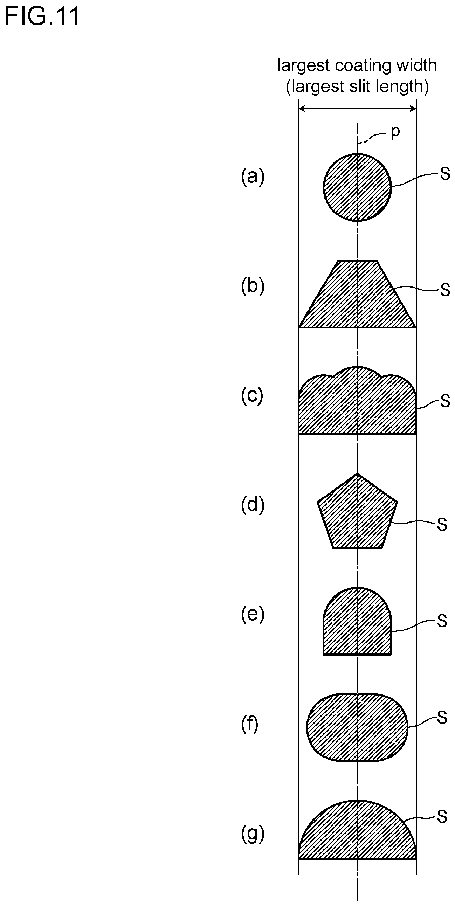

Fig. 10 is an explanatory view schematically showing an operation of the slit die 20 in forming a coated film S having a circular shape. Fig. 10 shows the correlation between the slit length of the slit-shaped nozzle 81 and the coated film S. Fig. 10(a) to Fig. 10(c) show a change in the slit length of the slit-shaped nozzle 81, and Fig. 10(d) shows a shape of the coated film S formed on the substrate 3. In the drawing, a bold arrow expresses a moving direction of the substrate 3. Fig. 10 shows the relation between the slit length and a coating width corresponding to the slit length by a two-dot chain line. Fig. 10(a) shows a state where the slit length is the smallest slit length, and Fig. 10 (c) shows a state where the slit length is the largest slit length. When the slit length is the largest slit length, the slit length corresponds to a diameter of the coated film S. Fig. 10 (b) shows an intermediate state between the state where the slit length is the smallest slit length and the state where the slit length is the largest slit length. By gradually decreasing the slit length from the largest slit length, the circular coated film can be formed. That is, by synchronizing a moving speed of the movable die plate 21 and the slit die 20 and a moving speed of the substrate 3, it is possible to form a coated film having an arbitrary shape which is in line symmetry with respect to the reference line P which forms an axis of symmetry. Fig. 11 shows examples of a coating shape.

Fig. 11 is a view showing examples of a shape of the coated film S when an ejection head mechanism unit 2A is used. As shown in Fig. 11 (a) to Fig. 11(g), provided that the shape takes a line symmetry with respect to the reference line P, the coated film S having an arbitrary shape such as a circular shape, a semi-circular shape, a quadrangular shape, a polygonal shape or a shape formed by combining these shapes can be formed within a range of the largest slit length.

### [Configuration of ejection head mechanism unit 2B]

The ejection head mechanism unit 2A described in Fig. 2 to Fig. 5 has the configuration which enables the center equally distributed coating in left and right symmetry with respect to the reference line P. On the other hand, the ejection head mechanism unit 2B has the configuration which enables the formation of the coated film S having arbitrary shapes on left and right sides with respect to the reference line P. To be more specific, the ejection head mechanism unit 2B differs from the ejection head mechanism unit 2Awith respect to a point that the ejection head mechanism unit 2B has a motor 91 dedicated to a slit die slide mechanism. The ejection head mechanism unit 2B has the same configuration with the ejection head mechanism unit 2Awith respect to a slit die 20 and a movable die plate slide mechanism 23.

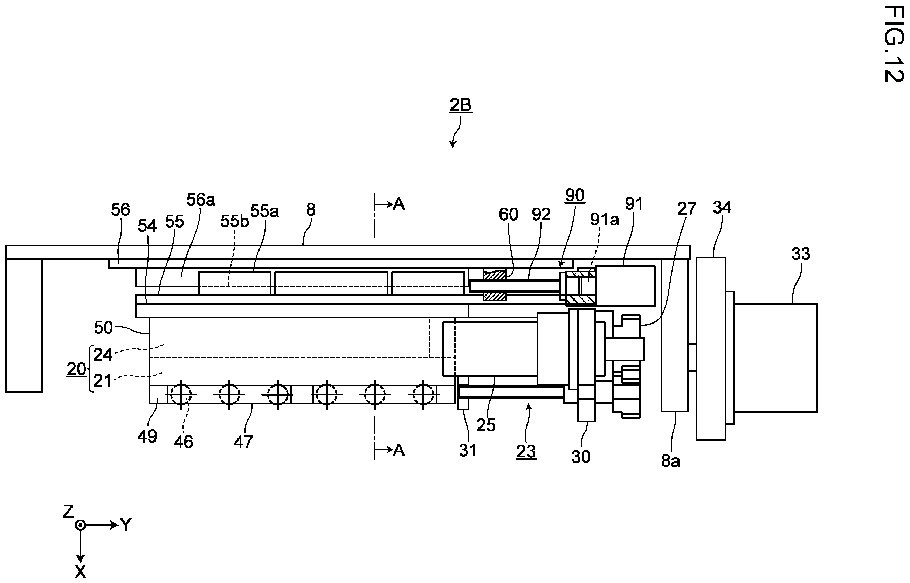

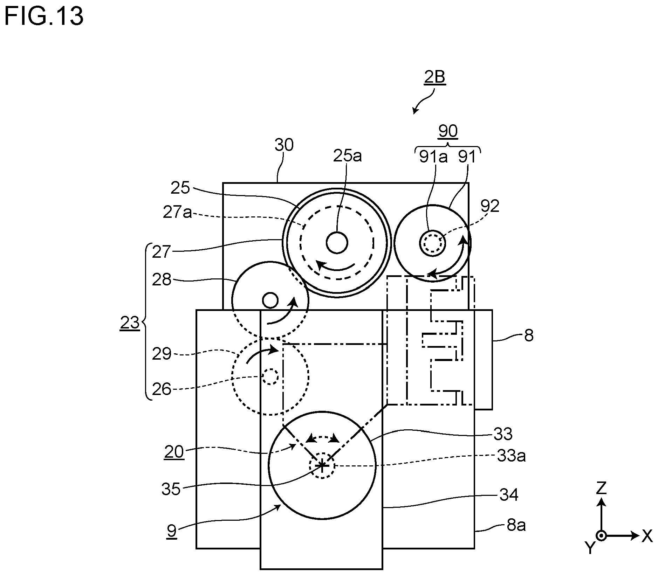

Fig. 12 is a plan view showing a configuration of the ejection head mechanism unit 2B, and Fig. 13 is a side view schematically showing an arrangement of a gear train and the motor 91 as viewed from a right side in Fig. 12. In Fig. 12, the description is made by focusing on portions which make the ejection head mechanism unit 2B differ from the ejection head mechanism unit 2A described in Fig. 3, and identical constitutional elements are given with the same symbols used in Fig. 3. Further, in Fig. 13, the description is made by mainly focusing on a point which makes the ejection head mechanism unit 2B differ from the ejection head mechanism unit 2A with respect to the gear train described in Fig. 5, and identical constitutional elements are given with the same symbols used in Fig. 5.

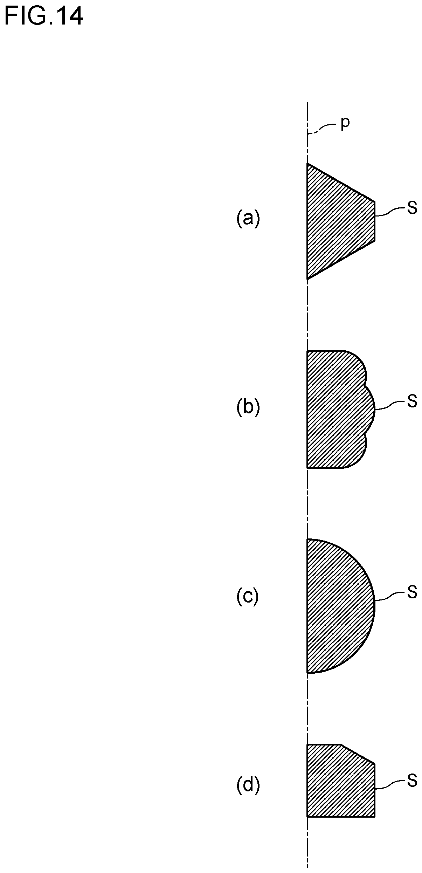

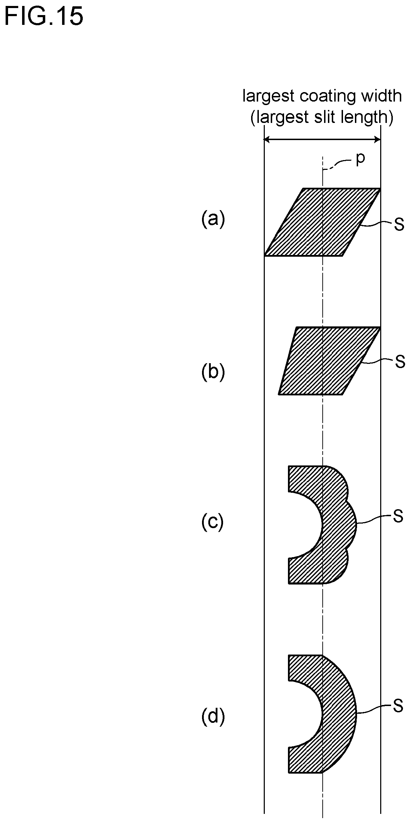

As shown in Fig. 12 and Fig. 13, the ejection head mechanism unit 2B includes a movable die plate slide mechanism 23 and a slit die slide mechanism 90. The slit die slide mechanism 90 is formed of a motor 91, and a screw shaft 59 connected with a motor shaft 91a by a coupling. The motor 91 is a servo motor capable of rotating in normal and reverse directions, and is fixedly mounted on a gear support plate 30. The motor 91 is disposed at a position spaced apart from a first gear 27. Left threads are formed on the screw shaft 92. Accordingly, when the motor 91 is rotated in a counterclockwise direction, a slit die 20 moves in a left direction in the drawing, and when the motor 91 is rotated in a clockwise direction, the slit die 20 moves in a right direction in a drawing. In the slit die slide mechanism 90, the motor 91 is directly connected to the screw shaft 92 and hence, the slit die slide mechanism 90 can be driven independently from a movable die plate slide mechanism 22. Therefore, the coated film S having the arbitrary shapes on the left and right sides with respect to the reference line P can be formed. The formation of the coated film S having arbitrary shapes on left and right sides with respect to the reference line P is described with reference to Fig. 14 and Fig. 15.

Fig. 14 is a view illustrating examples of a shape of the coated film S which can be formed when only the movable die plate slide mechanism 23 is driven in a state where the slit die slide mechanism 90 is stopped. With such an operation, the coated film S is formed only on a right side of the reference line P in the drawing. Fig. 14(a) shows a trapezoidal shape, Fig. 14(b) shows a shape having a waveform, Fig. 14(c) shows a semi-circular shape, and Fig. 14(d) shows a deformed pentagonal shape. Shapes of the coated film S shown in Fig. 14 are exemplified as an example, and a coated film having an arbitrary shape can be formed within a movable range of a movable die plate 21 with respect to the reference line P by suitably controlling a moving speed, a moving distance, a moving direction of the movable die plate 21 and a moving speed of the substrate 3.

Fig. 15 is a view illustrating examples of a shape of the coated film S which can be formed when the slit die slide mechanism 90 and the movable die plate slide mechanism 23 are driven in desired combinations. Coating shapes shown in Fig. 15(a) to Fig. 15(d) are exemplified as an example, and the coated film S having an arbitrary shape can be formed within a range of a largest coating width (largest slit length) by suitably controlling moving speeds, moving directions and moving distances of the slit die 20 and the movable die plate 23 and a moving speed of the substrate 3. By driving the slit die slide mechanism 90 and the movable die plate mechanism 23 in synchronism with each other, the coated film S having a line symmetrical shape with respect to the reference line P shown in Fig. 11 can also be formed.

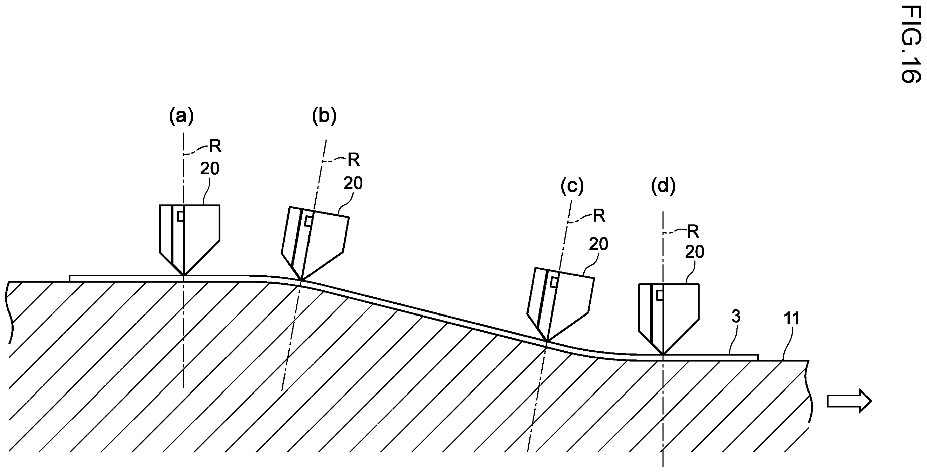

A substrate on which the slit coater 1 can form the coated film S is not limited to the substrate 3 having a horizontal flat surface, and the slit coater 1 can form the coated film S on the substrate 3 having a curved surface. The formation of the coated film S on the substrate 3 having a curved surface and an inclined surface is described with reference to Fig. 1 and Fig. 16.

Fig. 16 is an explanatory view schematically showing a method of forming the coated film S on the substrate 3 having a curved surface and an inclined surface. The formation of the coated film S is described by exemplifying the substrate 3 which is curved as shown in Fig. 16. Assume that the stage 11 has a shape which conforms with the substrate 3. A straight line R in the drawing expresses an extending line of the slit-shaped nozzle 81, and a bold arrow expresses a moving direction of the stage 11 (substrate 11). In Fig. 16, (a) indicates a mode where a liquid is coated on a horizontal flat portion of the substrate 3, and the straight line R is on a vertical line with respect to the substrate 3. Accordingly, (a) shows a state where the slit die 20 is moved to a position at which a liquid can be coated on the substrate 3 by a Z axis drive mechanism 7 (see Fig. 1) without inclining the slit die 20.

In Fig. 16, (b) shows a mode where a liquid is coated on a curved surface portion of the substrate 3, and the straight line R is on a normal line of a curved surface portion. Accordingly, (b) shows a state where the slit die 20 is inclined by the slit die rotating mechanism 9 (see Fig. 1) until a straight line R reaches the normal line, and the slit die 20 is moved to a position at which a liquid can be coated on the substrate 3 by the Z axis drive mechanism unit 7 (see Fig. 1) .

In Fig. 16, (c) shows a mode where a liquid is coated on an inclined surface of the substrate 3, and the straight line R is on a line perpendicular to an inclined surface portion. Accordingly, (c) shows a state where the slit die 20 is inclined by the slit die rotating mechanism 9 (see Fig. 1) until the straight line R reaches the line perpendicular to the inclined surface portion, and the slit die 20 is moved to a position at which a liquid can be coated on the substrate 3 by the Z axis drive mechanism unit 7 (see Fig. 1).

In Fig. 16, (d) shows a mode where a liquid is coated on a horizontal flat surface of the substrate 3, and a straight line R is on a vertical line with respect to the substrate 3. Accordingly, (d) shows a state where the slit die 20 is moved to a position at which the liquid can be coated on the substrate 3 by the Z axis drive mechanism unit 7 (see Fig. 1) without inclining the slit die 20.

That is, the coated film S can be formed on the substrate 3 where the curved surface and the inclined surface are continuously formed by controlling an inclination angle, an inclination direction and a height in the Z direction of the slit die 20 in conformity with a feeding speed of the substrate 3, and a curvature and an inclination angle of the substrate 3. Such a control can be performed in a controller (not shown in the drawings) by preliminarily programing data on a feeding speed of the substrate 3, a curvature of the substrate 3, an inclination angle and an inclination direction of the substrate 3, and a height of the substrate 3 in a Z direction.

Although not shown in the drawings, the controller includes a liquid amount controller. The liquid amount controller is a device which controls a supply amount of the liquid to the manifold 83 corresponding to a change in a slit length of the slit-shaped nozzle 81 and a moving speed of the substrate 3 in forming a coated film on the substrate 3 by ejecting the liquid onto the substrate 3. An ejection amount of the liquid is determined based on a size of the slit length and a moving speed of the substrate 3. The slit length can be detected based on a moving amount of the movable die plate 21, and a moving speed of the substrate 3 can be detected by the stage drive mechanism 4. By controlling a liquid supply amount corresponding to an ejection amount of the liquid by the liquid amount controller, a desired coated film shape can be formed with the supply of the liquid without an excess and a shortage of the liquid. Further, it is possible to prevent the generation of bubbles caused by a shortage of the liquid in a liquid supply path.

Alternatively, a feeding speed controller (not shown in the drawing) which controls a moving speed (feeding speed) of the substrate 3 may be used in place of the liquid amount controller. In the feeding speed controller, a moving speed of the substrate 3 is controlled in synchronism with a change in the slit length by setting a supply amount of the liquid to a constant value. For example, when the slit length is increased, an ejection amount is increased and hence, there is no possibility that the liquid becomes short by decreasing a feeding speed of the substrate 3. Further, when the slit length is decreased, it is possible to prevent an excessive ejection of the liquid by increasing a feeding speed of the substrate 3.

The slit coater 1 which has been described above includes: the slit die 20 mounted on the main frame 8, the slit die 20 including: the fixed die plate 24; the movable die plate 21 which is slidably movable in a length direction with respect to the fixed die plate 24; and the slit-shaped nozzle 81 which is formed on a joining face between the fixed die plate 24 and the movable die plate 21; the movable die plate slide mechanism 23 capable of changing a slit length of the slit-shaped nozzle 81 by moving the movable die plate 21; the slit die slide mechanism 22 capable of moving the slit die 20 along the main frame 8; and the stage drive mechanism 4 capable of sucking the substrate 3 which is a work onto the stage 11 and capable of transporting the substrate 3, wherein the shim plates 76, 71 capable of changing a size of a slit gap G of the slit-shaped nozzle 81 are detachably and fixedly mounted on the fixed die plate 24 and the movable die plate 21 respectively.

With such a configuration, the slit gap G of the slit-shaped nozzle 81 can be easily switched by changing thicknesses of two detachable shim plates 71, 76 interposed between the movable die plate 21 and the fixed die plate 24. The slit length, that is, the coating width can be freely controlled by moving the movable die plate 21 with respect to the fixed die plate 24 in the length direction of the slit-shaped nozzle 81. Accordingly, the slit coater 1 of the present invention can form a coated film having an arbitrary shape such as a rectangular shape, curved lines, or a combination of a straight line and a curved line. The slit coater 1 of the present invention can make use of characteristics of a conventional slit coating method, and can easily cope with a kind (difference in viscosity) and an ejection speed of a liquid to be ejected.

In the ejection head mechanism unit 2A, the movable die plate slide mechanism 23 and the slit die slide mechanism 22 are connected to one motor 25 by means of the first gear 27, the second gear 28, the third gear 29 and the fourth gear 32. In the ejection head mechanism unit 2A, a moving distance of the slit die 20 is 1/2 of a moving distance of the movable die plate 21, and a moving direction of the slit die 20 is a direction opposite to a moving direction of the movable die plate 21.

With such a configuration, the movable die plate 21 and the fixed die plate 24 synchronously move relative to each other in opposite directions. Since the moving distance of the slit die 20 is set to 1/2 of the moving distance of the movable die plate 24, distributed coating in line symmetry with respect to the reference line P, so-called center equally distributed coating can be performed. Accordingly, liquid coating having a quadrangular shape, a polygonal shape or a circular shape can be performed by controlling a moving speed and a moving distance of the movable die plate 21 and a moving speed (coating speed) of the substrate 3. For example, the coated film S having a circular shape which conforms with a profile of a semiconductor wafer can be formed.

In the ejection head mechanism unit 2B, the slit die slide mechanism 90 and the movable die plate slide mechanism 23 respectively have a motor 25, 91, and the motor 91 of the slit die slide mechanism 90 and the motor 25 of the movable die plate slide mechanism 23 are independently drivable from each other. With such a configuration, a moving speed, a moving direction and a moving distance of the slit die 20 can be arbitrarily controlled compared to a case where the slit length is changed by the movement of the movable die plate 21. Accordingly, the coated film having an arbitrary shape such as a rectangular shape, a polygonal shape or a combination of a straight line and a curved line can be formed. Needless to say that the center equally distributed coating can be also performed.

The movable die plate 21 and the fixed die plate 24 respectively have the manifold portion 80, 79 for supplying the liquid to the slit-shaped nozzle 81, the manifold portions 80, 79 communicate with each other so as to form one manifold 83, and a volume of the one manifold 83 is constant regardless of a moving position of the movable die plate 21.

With such a configuration, when the movable die plate 21 moves with respect to the fixed die plate 24, the volume of the manifold 83 does not change and hence, a liquid can be stably supplied to the slit-shaped nozzle 81 even when the slit length changes and hence, ejection uniformity can be ensured. That is, a thickness and a shape of the coated film can be formed with high accuracy. Particularly, although a volume of the slit-shaped nozzle 81 is increased along with the gradual increase of a slit length, the volume of the manifold 83 does not change and hence, it is possible to supply a liquid without an excess or a shortage of the liquid.

The movable die plate 21 and the fixed die plate 24 are guided by the parallel key 57 extending in a moving direction of the movable die plate 21. With such a configuration, when the movable die plate 21 is moved with respect to the fixed die plate 24, it is possible to prevent the movable die plate 21 from being inclined with respect to the fixed die plate 24 and hence, sliding property can be enhanced. Further, a gap formed between the discharge opening portion 35 of the slit-shaped nozzle 81 and the substrate 3 can be made uniform and hence, coating accuracy can be enhanced.

The slit coater 1 may further include the liquid amount controller capable of controlling a supply amount of the liquid to the manifold 83 corresponding to a change in a slit length of the slit-shaped nozzle 81 and a moving speed of the substrate 3 in forming a coated film S on the substrate 3 by ejecting the liquid onto the substrate 3. By controlling a liquid supply amount corresponding to an ejection amount of the liquid, a desired coated film shape can be formed with the supply of the liquid without an excess and a shortage of the liquid. Further, it is possible to prevent the generation of bubbles caused by a shortage of the liquid in a liquid supply path.

The slit coater 1 may include, in place of the above-mentioned liquid amount controller, a feeding speed controller capable of controlling a moving speed of the substrate 3 in synchronism with a change in the slit length by setting a supply amount of the liquid to a constant value. For example, when the slit length is increased, an ejection amount is increased and hence, there is no possibility that the liquid becomes short by decreasing a moving speed of the substrate 3. Further, when the slit length is decreased, it is possible to prevent an excessive ejection of the liquid by increasing a moving speed of the substrate 3.

In the slit die 20, the liquid which is an object to be coated is coated on a slide face between the movable die plate 21 and the fixed die plate 24. By preliminarily coating a liquid which is an object to be coated to the slide face (the surface 72c or the surface 75a) between the movable die plate and the fixed die plate 24, a film formed of the liquid becomes a lubricant and hence, sliding property between the movable die plate 21 and the fixed die plate 22 can be increased.

The slit coater 1 further includes the pressing unit formed of: the rollers 52 which press the movable die plate 21 to the fixed die plate 24; and the cam follower base 47 which supports the rollers 52. By bringing the movable die plate 21 and the fixed die plate 24 into close contact with each other by the rollers 52, the occurrence of a leakage of a liquid from the slide face (the surface 72c or the surface 75a) can be prevented and hence, the slit gap G can be maintained at a constant value. Further, by using the rollers 52 each of which is pivotally supported by way of a bearing as the pressing unit, the increase of a friction load of the movable die plate 21 can be suppressed and hence, sliding property can be maintained. By pressing a top surface of the movable die plate 21 downward from above the support frame 50, the movable die plate 21 is pressed to the parallel key 57 and hence, it is possible to prevent a leakage of a liquid from above the slit die 20.

The slit coater 1 may further include the slit die rotating mechanism unit 9 which is, in a state where the substrate 3 has a curved surface in a thickness direction, capable of inclining the slit die 20 so as to dispose the slit-shaped nozzle 81 on an extension of a normal line of the curved surface. By controlling an inclination angle of the slit die 20 by the slit die rotating mechanism unit 9, a coated film can be formed also on the substrate 3 having a curved surface or an inclined surface with high accuracy. When the substrate 3 has a flat surface, the slit die rotating mechanism unit 9 may be controlled such that the slit-shaped nozzle 81 is disposed on a line perpendicular to a flat surface. With such a configuration, a coated film can be formed also on the substrate 3 having a curved surface or an inclined surface.

The present invention is not limited to the above-mentioned embodiment, and the present invention embraces the modifications, improvements and the like within a range that the objects of the present invention can be achieved. For example, in the above-mentioned embodiment, the slit coater 1 is configured to include either one set of the ejection head mechanism unit 2A or one set of the ejection head mechanism unit 2B. However, the slit coater 1 may be configured to include either one of ejection head mechanism units 2A or the ejection head mechanism units 2B in plural sets such as two or three sets in series along the main frame 8. With such a configuration, it is possible to form the coated film S on a plurality of substrates at a time or to form coated films S in plural rows on one substrate. The ejection head mechanism unit 2A and the ejection head mechanism unit 2B may be arranged alternately.

In the above-mentioned embodiment, the substrate 3 is moved with respect to the ejection head mechanism unit 2A or the ejection head mechanism unit 2B. However, a configuration may be adopted where the ejection head mechanism unit 2A or the ejection head mechanism unit 2B is moved with respect to the substrate 3. Such a configuration can be realized by providing an X drive mechanism which moves the main frame 8 in the X direction. Further, a configuration may be adopted where both the X drive mechanism and the stage drive mechanism 4 are used.

### Reference Signs List

- 1:: slit coater
- 2, 2A, 2B:: ejection head mechanism unit
- 3:: substrate (work)
- 4:: stage drive mechanism unit
- 8:: main frame
- 9:: slit die rotating mechanism unit
- 11:: stage
- 12:: stage drive mechanism
- 20:: slit die
- 21:: movable die plate
- 22, 90:: slit die slide mechanism
- 23:: movable die plate slide mechanism
- 24:: fixed die plate
- 25, 33, 91:: motor
- 27:: first gear
- 28:: second gear
- 29:: third gear
- 32:: fourth gear
- 45:: pressing unit
- 47:: cam follower base
- 52:: roller
- 57:: parallel key
- 71, 76:: shim plate
- 72c, 75a:: surface (slide face)
- 79, 80:: manifold portion
- 81:: slit-shaped nozzle
- 82:: supply path
- 83:: manifold
- G:: slit gap
- P:: reference line

## Claims

1. A slit coater capable of forming a coated film by ejecting a liquid onto a work using a slit coating method, the slit coater comprising:
a slit die mounted on a main frame, the slit die including: a fixed die plate; a movable die plate which is slidably movable in a length direction with respect to the fixed die plate; and a slit-shaped nozzle which is formed on a joining face between the fixed die plate and the movable die plate;
a movable die plate slide mechanism capable of changing a slit length of the slit-shaped nozzle by slidably moving the movable die plate;
a slit die slide mechanism capable of slidably moving the slit die along the main frame; and
a stage drive mechanism capable of sucking work onto a stage and capable of transporting the work, wherein
shim plates which define a size of a slit gap of the slit-shaped nozzle are respectively detachably and fixedly mounted on the fixed die plate and the movable die plate.

2. The slit coater according to claim 1, wherein the movable die plate slide mechanism and the slit die slide mechanism are connected to one motor by means of a plurality of gears,
a moving distance of the slit die is 1/2 of a moving distance of the movable die plate, and
a moving direction of the slit die is a direction opposite to a moving direction of the movable die plate.

3. The slit coater according to claim 1, wherein the slit die slide mechanism and the movable die plate slide mechanism each have a motor, and the motor of the slit die slide mechanism and the motor of the movable die plate slide mechanism are driven independently from each other.

4. The slit coater according to any one of claims 1 to 3, wherein the movable die plate and the fixed die plate each have a manifold portion for supplying the liquid to the slit-shaped nozzle,
the manifold portion of the movable die plate and the manifold portion of the fixed die plate communicate with each other so as to form one manifold, and
a volume of the one manifold is constant regardless of a moving position of the movable die plate.

5. The slit coater according to any one of claims 1 to 4, wherein the movable die plate and the fixed die plate are guided by a parallel key extending in a moving direction of the movable die plate.

6. The slit coater according to any one of claims 1 to 5, further comprising a liquid amount controller capable of controlling a supply amount of the liquid to the manifold corresponding to a change in a slit length of the slit-shaped nozzle and a moving speed of the work in forming a coated film on the work by ejecting the liquid onto the work.

7. The slit coater according to any one of claims 1 to 5, further comprising a feeding speed controller capable of controlling a moving speed of the work in synchronism with a change in the slit length by setting a supply amount of the liquid to a constant value.

8. The slit coater according to any one of claims 1 to 7, wherein the liquid which is an object to be coated is coated on a slide face between the movable die plate and the fixed die plate.

9. The slit coater according to any one of claims 1 to 8, further comprising a pressing unit formed of: a roller which presses the movable die plate to the fixed die plate; and a cam follower base which supports the roller.

10. The slit coater according to any one of claims 1 to 9, further comprising a slit die rotating mechanism unit which is, in a state where the work has a curved surface in a thickness direction, capable of inclining the slit die so as to dispose the slit-shaped nozzle on an extension of a normal line of the curved surface.
